# EUROPEAN PATENT APPLICATION

(11) **EP 4 514 081 A1**
(43) Date of publication of application: **26.02.2025**
(21) Application number: 23806598.1
(22) Date of filing: 20.03.2023
(51) Int. Cl.: H05K 7/20

(54) **HEAT DISSIPATION APPARATUS, CONNECTING STRUCTURE, AND ELECTRONIC DEVICE**

(30) Priority: 20.05.2022 CN 202210559723
(71) Applicant: Huawei Technologies Co., Ltd., Shenzhen, Guangdong 518129 (CN)
(72) Inventor: HE, Zhi, Shenzhen, Guangdong 518129 (CN); LI, Chunrong, Shenzhen, Guangdong 518129 (CN); YUAN, Baojun, Shenzhen, Guangdong 518129 (CN); ZHANG, Zhao, Shenzhen, Guangdong 518129 (CN)
(74) Representative: Pfenning, Meinig & Partner mbB
(86) International application number: PCT/CN2023/082503
(87) International publication number: WO 2023/221638

(57) **Abstract**

Embodiments of this application relate to a heat dissipation apparatus, a connection structure, and an electronic device. A first heat sink (110a) is in thermal contact with a first heat-generating device (201a) on a first component (200a), and a second heat sink (110b) is in thermal contact with a second heat-generating device (201b) on a second component (200b). The first heat sink (110a) and the second heat sink (110b) are communicated through a pipeline (120), and the three are filled with a cooling medium. Heat generated by either of the first heat-generating device (201a) and the second heat-generating device (201b) may be transferred to the cooling medium in the heat sink through the corresponding heat sink, and the heat is dissipated outward through a surface of the heat sink. When heat-generating devices on different components have a specific temperature difference, a heat sink corresponding to a high-temperature heat-generating device transfers heat to a heat sink corresponding to a low-temperature heat-generating device or non-working heat-generating device by using the cooling medium, to implement uniform temperature heat dissipation effect of the first heat-generating device (201a) and the second heat-generating device (201b) on different components. This improves a heat dissipation capability. The heat dissipation apparatus (100) is low-cost, easy to implement, easy to deploy, does not require a large pump body, pipeline, heat exchanger, and the like to be disposed in an equipment room, and does not require additional indoor space.

## Description

This application claims priority to Chinese Patent Application No. 202210559723.X, filed with the China National Intellectual Property Administration on May 20, 2022 and entitled "HEAT DISSIPATION APPARATUS, CONNECTION STRUCTURE, AND ELECTRONIC DEVICE", which is incorporated herein by reference in its entirety.

### TECHNICAL FIELD

Embodiments of this application relate to the field of heat dissipation structure technologies, and in particular, to a heat dissipation apparatus, a connection structure, and an electronic device.

### BACKGROUND

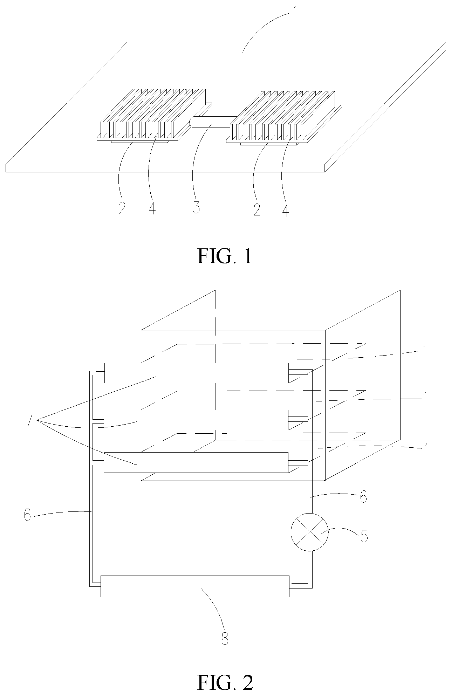

As electronic devices develop, power consumption of a heat-generating device (like a chip) in a device is increasingly high. In a case in which a device or component (for example, a board) has a plurality of heat-generating devices, to implement uniform temperature heat dissipation of different heat-generating devices, as shown in FIG. 1, in the conventional technology, a heat pipe 3 or a vapor chamber (vapor chamber, VC) lid may be used to connect heat sinks 4 corresponding to two chips 2 on a same board 1. Because the heat pipe 3 is rigid, the heat pipe 3 cannot be moved after being welded to the two heat sinks 4. This manner can be applied only to a scenario of the same board 1. As shown in FIG. 2, a liquid cooling manner of a pump body + a pipeline + a heat exchanger (heat exchanger, HEX) may also be used in the conventional technology. A pump body 5 drives a cooling medium to flow in a pipeline 6, and the cooling medium passing through each board branch 7 absorbs heat of a heat-generating device. The cooling medium converges and performs heat exchange in a heat exchanger 8, and the cooling medium is sent to each board branch 7 after the heat exchange. In this manner, the pump body 5, the pipeline 6, the heat exchanger 8 (like a cooling tower), and the like need to be arranged in an equipment room, and large indoor space is occupied.

### SUMMARY

Embodiments of this application provide a heat dissipation apparatus, a connection structure, and an electronic device, to resolve a problem in the conventional technology that uniform temperature heat dissipation of heat-generating devices on different components is difficult to be implemented in a case of small space.

The following technical solutions are used in embodiments of this application.

According to a first aspect, an embodiment of this application provides a heat dissipation apparatus, including: a first heat sink, a second heat sink, and a pipeline. The first heat sink has a first inner cavity, the second heat sink has a second inner cavity, the first heat sink is in thermal contact with a first heat-generating device located on a first component, and the second heat sink is in thermal contact with a second heat-generating device located on a second component. The first heat sink communicates with the second heat sink through the pipeline, and the first inner cavity, the second inner cavity, and the pipeline are filled with a cooling medium.

For example, the first component and the second component may be boards or other structures, and the first heat-generating device and the second heat-generating device may be chips or other devices disposed on the boards.

According to the heat dissipation apparatus in this embodiment of this application, the first heat sink is in thermal contact with the first heat-generating device on the first component, the second heat sink is in thermal contact with the second heat-generating device on the second component, the first heat sink communicates with the second heat sink through the pipeline, and the first heat sink, the second heat sink, and the pipeline are filled with a cooling medium. Heat generated by either of the first heat-generating device and the second heat-generating device may be transferred to a cooling medium in a heat sink through the corresponding heat sink, and the heat is dissipated outward through a surface of the heat sink. When heat-generating devices on different components have a specific temperature difference, a heat sink corresponding to a high-temperature heat-generating device transfers heat to a heat sink corresponding to a low-temperature heat-generating device or non-working heat-generating device by using the cooling medium, to implement uniform temperature heat dissipation effect of the first heat-generating device and the second heat-generating device on different components. This improves a heat dissipation capability. The heat dissipation apparatus is low-cost, easy to implement, easy to deploy, does not require a large pump body, pipeline, heat exchanger, and the like to be disposed in an equipment room, and does not require additional indoor space.

In an optional implementation, the first component is a first board, and/or the second component is a second board.

The heat dissipation apparatus in this embodiment of this application is used in a plurality of boards, to dissipate heat of heat-generating devices on different boards at an even temperature.

In an optional implementation, the pipeline is a heat pipe.

Two ends of the heat pipe are respectively connected to the first heat sink and the second heat sink. Either the first heat-generating device or the second heat-generating device works to generate heat, so that one end of the heat pipe is heated. Heat is transferred from one end of the heat pipe to the other end. Heat sink resources are shared to improve a heat dissipation capability.

In an optional implementation, the first heat sink, the pipeline, and the second heat sink are communicated to form a circulation loop, the pipeline is connected to a pump body, and the pump body is configured to drive the cooling medium to flow in the circulation loop.

Liquid cooling is performed on the first heat-generating device and the second heat-generating device through a fluid path with the pump body, and heat is dissipated outward through the first heat sink and the second heat sink. Heat sink resources are shared to improve a heat dissipation capability.

In an optional implementation, the first heat sink, the pipeline, and the second heat sink are communicated to form a circulation loop, and the pipeline includes a first sub-pipeline. The first heat sink has a first liquid inlet and a first liquid outlet, the second heat sink has a second liquid inlet and a second liquid outlet, and the first liquid outlet communicates with the second liquid inlet through the first sub-pipeline.

In this solution, communication between the first heat sink and the second heat sink can be implemented.

In an optional implementation, the first sub-pipeline includes a first liquid inlet pipe connected to the second liquid inlet, a first liquid outlet pipe connected to the first liquid outlet, and a first connection pipe connecting the first liquid inlet pipe and the first liquid outlet pipe. The first liquid outlet pipe communicates with the first connection pipe through a pluggable connector.

After the first component is assembled to a predetermined position, an end of the first connection pipe is connected to the first liquid outlet pipe through the pluggable connector, to improve assembly efficiency and facilitate disassembly and maintenance.

In an optional implementation, both the pluggable connector and the first connection pipe are disposed on a front panel or a rear panel of a device.

The pluggable connector and the first connection pipe are arranged on a same side component, to facilitate assembly of the first connection pipe and the pluggable connector.

In an optional implementation, the apparatus further includes a second connection pipe, and the first connection pipe and the second connection pipe are crosswise disposed.

A plurality of connection pipes are crosswise disposed, so that the plurality of connection pipes may be disposed on a same side. In this way, limited space can be fully utilized.

In an optional implementation, the first heat sink, the pipeline, and the second heat sink are communicated to form a circulation loop. A control valve is disposed on the pipeline, and connection and disconnection switching of the pipeline may be controlled by using the control valve.

Heat generated by heat-generating devices on different boards is close to or equal to each other, the pump body is turned off and the control valve is closed, a cooling medium in the circulation loop does not flow, and the heat generated by the heat-generating device is conducted to a cooling medium in the heat sink through the corresponding heat sink, and the heat is dissipated outward through the heat sink.

In an optional implementation, the first heat sink, the pipeline, and the second heat sink are communicated to form a circulation loop, and a one-way valve is disposed on the pipeline.

The one-way valve is disposed, so that the cooling medium in the circulation loop can flow only in a same direction, and cannot flow reversely. This prevents the cooling medium from flowing back to the heat sink.

In an optional implementation, there are a plurality of heat fins that are distributed at intervals on a side that is of the first heat sink and that is opposite to the first heat-generating device. Heat generated by the first heat-generating device during working is conducted to the heat fins through the first heat sink, and then transferred to a surrounding environment through the heat fins. This effectively improves a heat dissipation capability.

According to a second aspect, an embodiment of this application provides a connection structure, including the foregoing heat dissipation apparatus, the foregoing first heat-generating device, and the foregoing second heat-generating device. The first heat-generating device is in thermal contact with the first heat sink, and the second heat-generating device is in thermal contact with the second heat sink.

According to the connection structure in this embodiment of this application, when heat-generating devices on different components have a specific temperature difference, a heat sink corresponding to a high-temperature heat-generating device transfers heat to a heat sink corresponding to a low-temperature heat-generating device by using a cooling medium, to implement uniform temperature heat dissipation effect of the heat-generating devices on different components. This improves a heat dissipation capability. A large pump body, pipeline, and heat exchanger are not required in an equipment room, and no additional indoor space is required.

In an optional implementation, the first component is a first board, the second component is a second board, and the first board and the second board are stacked.

In this manner, a structure is compact and small space is occupied. The heat dissipation apparatus in this embodiment of this application is used to form a cross-board heat balancing system, to implement uniform temperature heat dissipation effect of heat-generating devices on different boards.

In an optional implementation, the first component is located on a first electronic device, and the second component is located on a second electronic device.

Heat-generating devices of components on different electronic devices share the heat dissipation apparatus in this embodiment of this application, to form a cross-board heat balancing system. This can implement uniform temperature heat dissipation effect of heat-generating devices of different electronic devices.

According to a third aspect, an embodiment of this application provides an electronic device, including the foregoing heat dissipation apparatus or the foregoing connection structure.

Because the foregoing heat dissipation apparatus or connection structure is used, heat-generating devices on different components share a heat sink. This improves an overall heat dissipation capability.

### BRIEF DESCRIPTION OF DRAWINGS

FIG. 1 is a diagram of a structure in which two heat sinks on a board are communicated through a heat pipe in the conventional technology;
FIG. 2 is a diagram of a structure in which a plurality of boards use a liquid cooling manner in the conventional technology;
FIG. 3 is a diagram of a structure of a heat dissipation apparatus according to an embodiment of this application;
FIG. 4 is an exploded diagram of a heat dissipation apparatus according to another embodiment of this application;
FIG. 5 is a three-dimensional assembly diagram of the heat dissipation apparatus in FIG. 4;
FIG. 6 is an exploded three-dimensional diagram of a heat dissipation apparatus according to another embodiment of this application;
FIG. 7 is a diagram of a structure of another side of a partial structure of the heat dissipation apparatus in FIG. 6;
FIG. 8 is a three-dimensional assembly diagram of the heat dissipation apparatus in FIG. 6;
FIG. 9 is a three-dimensional assembly diagram of a heat dissipation apparatus according to another embodiment of this application;
FIG. 10 is a diagram of a structure of another side of a partial structure of the heat dissipation apparatus in FIG. 9; and
FIG. 11 is a flowchart of a heat dissipation method for an electronic device according to an embodiment of this application.

### DESCRIPTION OF EMBODIMENTS

To make the technical problems to be resolved, technical solutions, and beneficial effect in this application clearer, the following further describes this application in detail with reference to the accompanying drawings and embodiments. It should be understood that the specific embodiments described herein are merely used to explain this application but are not intended to limit this application. Although descriptions of this application are described with reference to some embodiments, it does not mean that features of this application are limited to the implementations. On the contrary, a purpose of introducing the application with reference to the implementations is to cover other options or modifications that may be extended based on the claims of this application. To provide a deep understanding of this application, the following descriptions include many specific details. This application may also be implemented without using these details. In addition, to avoid confusion or obscureness of a focus of this application, some specific details are omitted in the descriptions. It should be noted that, in a case of no conflict, embodiments in this application and features in the embodiments may be mutually combined.

It should be noted that when an element is referred to as being "fastened to" or "disposed on" another element, the element may be directly or indirectly on the another element. When an element is referred to as being "connected to" another element, the element may be directly or indirectly connected to the another element.

In descriptions of embodiments of this application, it should be noted that, unless otherwise clearly specified and limited, terms such as "mounting" and "connection" should be understood in a broad sense. For example, the "connection" may be a detachable connection, a nondetachable connection; and may be a direct connection, or may be an indirect connection through an intermediary. An orientation or position relationship indicated by terms "length", "width", "up", "down", "front", "rear", "left", "right", "vertical", "horizontal", "top", "bottom", "inside", "outside", and the like is based on an orientation or position relationship shown in the accompanying drawings. This is merely intended to facilitate description of this application and simplify the description, but is not intended to indicate or imply that the referred apparatus or element needs to have a specific orientation, be constructed and operated in a specific orientation. Therefore, this cannot be construed as a limitation on this application.

In addition, the terms "first" and "second" are merely intended for a purpose of description, and shall not be understood as an indication or implication of relative importance or implicit indication of a quantity of indicated technical features. Therefore, a feature limited by "first" or "second" may explicitly or implicitly include one or more features. In the description of this application, "a plurality of" means two or more than two, unless otherwise specifically limited.

The term "and/or" in embodiments of this application describes only an association relationship for describing associated objects and represents that three relationships may exist. For example, A and/or B may represent the following three cases: Only A exists, both A and B exist, and only B exists. In addition, a character "/" in this specification generally indicates an "or" relationship between associated objects.

Reference to "an embodiment", "some embodiments", or the like described in this specification indicates that one or more embodiments of this application include specific features, structures, or characteristics described with reference to the embodiments. Therefore, statements such as "in an embodiment", "in some embodiments", "in some other embodiments", and "in other embodiments" that appear at different places in this specification do not necessarily refer to a same embodiment. Instead, the statements mean "one or more but not all of embodiments", unless otherwise specifically emphasized in another manner. Terms "include", "contain", "have", and variants thereof all mean "including, but not limited to", unless otherwise specifically emphasized in another manner.

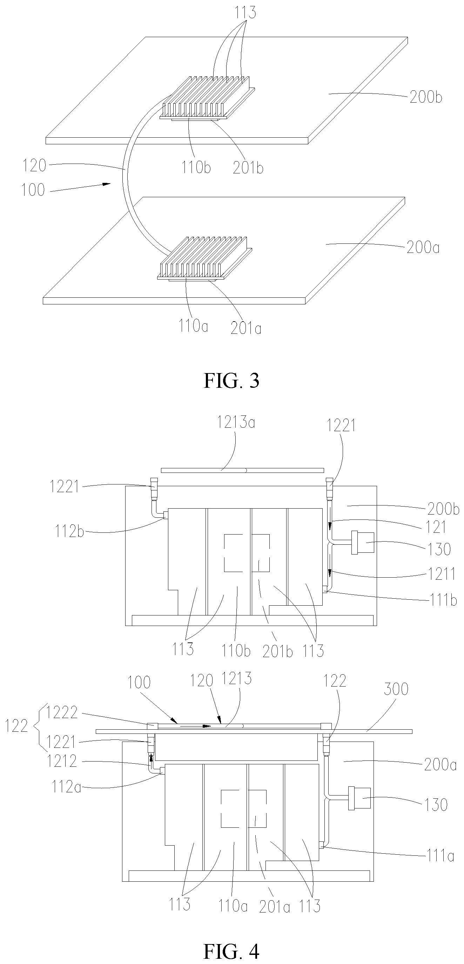

As shown in FIG. 3 to FIG. 5, an embodiment of this application provides a heat dissipation apparatus 100, including a first heat sink 110a, a second heat sink 110b, and a pipeline 120. The first heat sink 110a has a first inner cavity, the second heat sink 110b has a second inner cavity, the first heat sink 110a is in thermal contact with a first heat-generating device 201a located on a first component 200a, and the second heat sink 110b is in thermal contact with a second heat-generating device 201b located on a second component 200b. The first heat sink 110a communicates with the second heat sink 110b through the pipeline 120, and the first inner cavity, the second inner cavity, and the pipeline 120 are filled with a cooling medium.

For example, the first component 200a and the second component 200b may be boards or other structures, and the first heat-generating device 201a and the second heat-generating device 201b may be chips or other devices disposed on the boards.

The cooling medium may be water, fluoride liquid, heat transfer oil, or the like. When the cooling medium is used in a heat pipe, a liquid cooling medium evaporates when it is hot, and a gas cooling medium liquefies when it is cold. When the cooling medium is used in a fluid path with a pump body, the cooling medium is kept in a liquid state.

According to the heat dissipation apparatus 100 in this embodiment of this application, the first heat sink 110a is in thermal contact with the first heat-generating device 201a on the first component 200a, the second heat sink 110b is in thermal contact with the second heat-generating device 201b on the second component 200b, the first heat sink 110a communicates with the second heat sink 110b through the pipeline 120, and the first heat sink 110a, the second heat sink 110b, and the pipeline 120 are filled with the cooling medium. Heat generated by either of the first heat-generating device 201a and the second heat-generating device 201b may be transferred to a cooling medium in a heat sink through the corresponding heat sink, and the heat is dissipated outward through a surface of the heat sink. When heat-generating devices on different components have a specific temperature difference, a heat sink corresponding to a high-temperature heat-generating device transfers heat to a heat sink corresponding to a low-temperature heat-generating device or non-working heat-generating device by using the cooling medium, to implement uniform temperature heat dissipation effect of the first heat-generating device 201a and the second heat-generating device 201b on different components. This improves a heat dissipation capability. The heat dissipation apparatus 100 is low-cost, easy to implement, easy to deploy, does not require a large pump body, pipeline, heat exchanger, and the like to be disposed in an equipment room, and does not require additional indoor space.

In some embodiments, the first component 200a is a first board, and the second component 200b is a second board. The heat dissipation apparatus 100 in this embodiment of this application is used in a plurality of boards, to dissipate heat of heat-generating devices on different boards at an even temperature. A board has a non-working heat-generating device, the board may be in a backup state, power consumption is low, and a temperature of a heat sink corresponding to the non-working heat-generating device is low.

When the heat sink is disposed, the first heat sink 110a and the second heat sink 110b may be disposed in a flat shell shape or a box shape, and a side of the heat sink may be attached to a corresponding heat-generating device, so that heat generated by the heat-generating device is transferred to a cooling medium in the heat sink through the heat sink.

In some embodiments, as shown in FIG. 3, the pipeline 120 is a heat pipe. Two ends of the heat pipe are respectively connected to the first heat sink 110a and the second heat sink 110b. There is a capillary porous material in the heat pipe. Either the first heat-generating device 201a or the second heat-generating device 201b works to generate heat, so that an end of the heat pipe is heated. When either end of the heat pipe is heated, the end of the heat pipe is used as an evaporation end, and the other end dissipates heat outward and becomes a condensation end. A cooling medium in the capillary porous material inside the evaporation end absorbs heat and evaporates. A gas cooling medium flows to the condensation end under a small pressure difference, releases heat, and recondenses into a liquid cooling medium. The liquid cooling medium flows back to the evaporation end along the capillary porous material by using a capillary force. In this way, heat is transferred from one end of the heat pipe to the other end. Heat sink resources are shared to improve a heat dissipation capability.

For example, the first heat-generating device 201a and the second heat-generating device 201b are respectively disposed on different boards, and the heat pipe is connected between the first heat sink 110a and the second heat sink 110b, so that heat can be transferred from a heat sink corresponding to a high-temperature heat-generating device to a heat sink corresponding to a low-temperature heat-generating device by using the cooling medium. When the heat pipe is disposed, the heat pipe may be disposed on a front panel or a rear panel 300 of the electronic device, and does not occupy additional equipment room space.

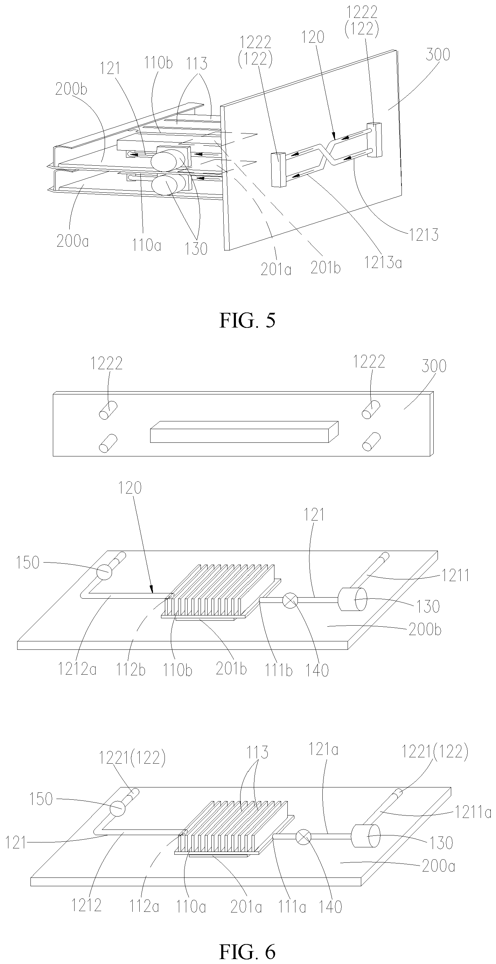

In some embodiments, as shown in FIG. 4 and FIG. 5, the first heat sink 110a, the pipeline 120, and the second heat sink 110b are communicated to form a circulation loop, the pipeline 120 is connected to a pump body 130, and the pump body 130 is configured to drive a cooling medium to flow in the circulation loop. Arrows on pipelines in FIG. 4 and FIG. 5 indicate flow directions of the cooling medium.

Liquid cooling is performed on the first heat-generating device 201a and the second heat-generating device 201b through a fluid path with the pump body 130, and heat is dissipated outward through the first heat sink 110a and the second heat sink 110b. Heat sink resources are shared to improve a heat dissipation capability. When the first component 200a and the second component 200b are boards, small pump bodies 130 may be selected and disposed on the boards, as long as the cooling medium in the circulation loop is driven. The pipeline 120 may be disposed near the boards, and is easy to deploy, without occupying additional indoor space of an equipment room.

In some embodiments, as shown in FIG. 4 and FIG. 5, the first heat sink 110a, the pipeline 120, and the second heat sink 110b are communicated to form a circulation loop. The pipeline 120 includes a first sub-pipeline 121. The first heat sink 110a has a first liquid inlet 111a and a first liquid outlet 112a. The second heat sink 110b has a second liquid inlet 111b and a second liquid outlet 112b. The first liquid outlet 112a communicates with the second liquid inlet 111b through the first sub-pipeline 121. In this solution, communication between the first heat sink 110a and the second heat sink 110b can be implemented.

The first liquid outlet 112a and the second liquid inlet 111b communicate through the first sub-pipeline 121, and the second liquid outlet 112b and the first liquid inlet 111a (and more liquid outlets and liquid inlets of heat sinks) communicate through another sub-pipeline, to form circulation loops, and the pump body 130 drives a cooling medium to flow in the circulation loops. When heat-generating devices on different components generate different heat, heat of a high-temperature heat-generating device is conducted to a cooling medium in a heat sink through the heat sink corresponding to the high-temperature heat-generating device, and the cooling medium with high heat is transferred to a heat sink corresponding to a low-temperature heat-generating device or a non-working heat-generating device through the first sub-pipeline 121 or another sub-pipeline. This implements sharing of heat dissipation resources of the heat sink and improves overall heat dissipation effect.

To facilitate communication between the first heat sink 110a and the second heat sink 110b through the first sub-pipeline 121, in some embodiments, as shown in FIG. 4 and FIG. 5, the first sub-pipeline 121 includes a first liquid inlet pipe 1211 connected to the second liquid inlet 111b, a first liquid outlet pipe 1212 connected to the first liquid outlet 112a, and a first connection pipe 1213 connecting the first liquid inlet pipe 1211 and the first liquid outlet pipe 1212. The first liquid outlet pipe 1212 communicates with the first connection pipe 1213 through a pluggable connector 122.

In this embodiment, the first sub-pipeline 121 is disposed as the first liquid inlet pipe 1211, the first liquid outlet pipe 1212, and the first connection pipe 1213. The first liquid inlet pipe 1211 and the first liquid outlet pipe 1212 are respectively connected to the second liquid inlet 111b and the first liquid outlet 112a. After the first component 200a is assembled to a predetermined position, an end of the first connection pipe 1213 is connected to the first liquid outlet pipe 1212 through the pluggable connector 122, to improve assembly efficiency and facilitate disassembly and maintenance.

In addition, the first liquid inlet pipe 1211 and the first connection pipe 1213 may be directly connected or connected through the pluggable connector 122. When the pluggable connector 122 is used between the first liquid inlet pipe 1211 and the first connection pipe 1213, assembly efficiency is improved, and disassembly and maintenance are facilitated.

There are a plurality of optional implementations for disposing the pluggable connector 122.

A first implementation of the pluggable connector 122 is a manner in which a male connector is connected to a female connector. For example, the male connector and the female connector are respectively disposed on a port of the first liquid outlet pipe 1212 and a port of the first connection pipe 1213, so that the first liquid outlet pipe 1212 and the first connection pipe 1213 can be detachably connected.

A second implementation of the pluggable connector 122: as shown in FIG. 4 and FIG. 5, a plug 1221 and a socket 1222 are used, and both the plug 1221 and the socket 1222 have a flow channel. For example, the plug 1221 is disposed on a port of the first liquid outlet pipe 1212, the socket 1222 is disposed on a predetermined mechanical part, one end of the flow channel of the socket 1222 is connected to an end of the first connection pipe 1213, and the other end of the flow channel of the socket 1222 is plugged by the plug 1221. When the plug 1221 is inserted into the socket 1222, the first liquid outlet pipe 1212 and the first connection pipe 1213 can be detachably connected.

In some embodiments, as shown in FIG. 4 and FIG. 5, both the pluggable connector 122 and the first connection pipe 1213 are disposed on a front panel or a rear panel 300 of a device. The pluggable connector 122 and the first connection pipe 1213 are arranged on a same side component, to facilitate assembly of the first connection pipe 1213 and the pluggable connector 122.

For example, as shown in FIG. 4 and FIG. 5, both the first component 200a and the second component 200b are boards. The pluggable connector 122 uses the plug 1221 and the socket 1222. The socket 1222 is fastened to the rear panel 300, and the connection pipe 1213 is connected between different sockets 1222. A plurality of boards are stacked, liquid inlet pipes and liquid outlet pipes on different boards are disposed toward the rear panel 300, and plugs 1221 are respectively disposed at ports of the liquid inlet pipes and the liquid outlet pipes. After the boards are assembled, the plug 1221 is inserted into the socket 1222 of the rear panel 300, so that the heat sinks on the boards are connected to form a circulation loop. This facilitates assembly of the plurality of boards and the heat dissipation apparatus 100.

In another embodiment, the pluggable connector 122 further uses the plug 1221 and the socket 1222, and the socket 1222 may be fastened to the front panel. This also facilitates assembly of the plurality of boards and the heat dissipation apparatus 100.

In some embodiments, as shown in FIG. 4 and FIG. 5, a second connection pipe 1213a is further included, and the first connection pipe 1213 and the second connection pipe 1213a are crosswise disposed. The second connection pipe 1213a is a pipe connected to two heat sinks. For example, the second connection pipe 1213a is connected to the first liquid inlet 111a of the first heat sink 110a and the second liquid outlet 112b of the second heat sink 110b. For another example, the second connection pipe is connected to the second liquid outlet 112b of the second heat sink 110b and a liquid inlet of another heat sink. A plurality of connection pipes are crosswise disposed, so that the plurality of connection pipes may be disposed on a same side, for example, a same vertical plane. In this way, limited space can be fully used.

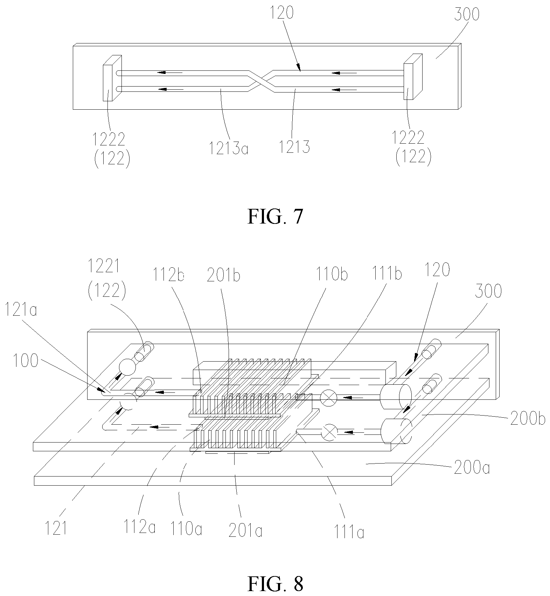

For example, as shown in FIG. 6 to FIG. 8, the first component 200a having the first heat-generating device 201a and the second component 200b having the second heat-generating device 201b are disposed. The first heat sink 110a is disposed on the first heat-generating device 201a, and the second heat sink 110b is disposed on the second heat-generating device 201b. The two heat sinks are connected through the first sub-pipeline 121 and a second sub-pipeline 121a. The first sub-pipeline 121 includes the first liquid outlet pipe 1212, the first connection pipe 1213, and the first liquid inlet pipe 1211 that can be sequentially connected. The second sub-pipeline 121a includes a second liquid outlet pipe 1212a, the second connection pipe 1213a, and a second liquid inlet pipe 1211a that can be sequentially connected. With reference to FIG. 7, the first connection pipe 1213 and the second connection pipe 1213a are crosswise distributed.

With reference to FIG. 8, the first liquid outlet 112a of the first heat sink 110a is connected to the second liquid inlet 111b of the second heat sink 110b through the first sub-pipeline 121, and the second liquid outlet 112b of the second heat sink 110b is connected to the first liquid inlet 111a of the first heat sink 110a through the second sub-pipeline 121a, to form a circulation loop. Arrows on the pipelines in FIG. 7 and FIG. 8 indicate a flow direction of a cooling medium, and the pump body 130 may drive the cooling medium in the circulation loop to flow, to implement sharing of heat sinks on different components.

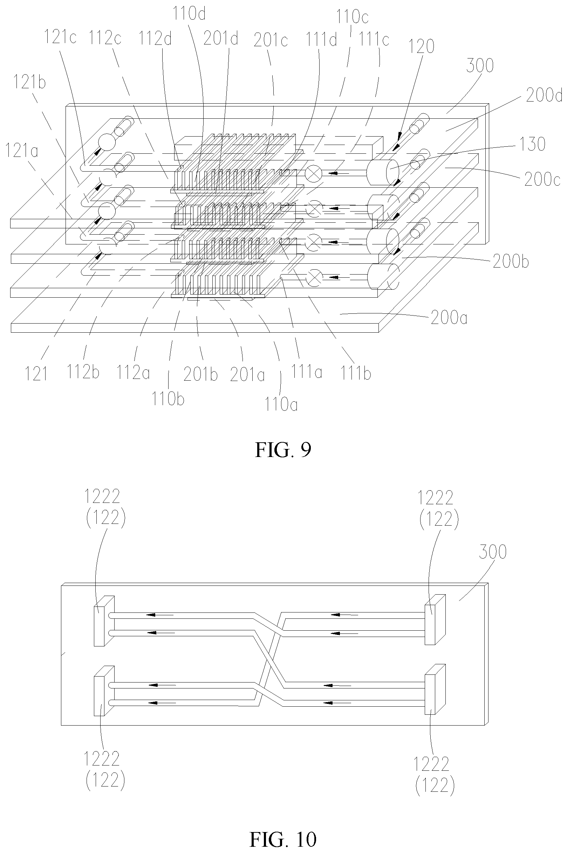

For example, as shown in FIG. 9 and FIG. 10, the first component 200a having the first heat-generating device 201a, the second component 200b having the second heat-generating device 201b, a third component 200c having a third heat-generating device 201c, and a fourth component 200d having a fourth heat-generating device 201d are disposed. The first heat sink 110a is disposed on the first heat-generating device 201a, the second heat sink 110b is disposed on the second heat-generating device 201b, a third heat sink 110c is disposed on the third heat-generating device 201c, and a fourth heat sink 110d is disposed on the fourth heat-generating device 201d. The four heat sinks are connected through the first sub-pipeline 121, the second sub-pipeline 121a, a third sub-pipeline 121b, and a fourth sub-pipeline 121c in sequence. Each sub-pipeline includes a liquid outlet pipe, a connection pipe, and a liquid inlet pipe that are sequentially connected. With reference to FIG. 10, some connection pipes in all sub-pipelines are crosswise disposed.

With reference to FIG. 9, the first liquid outlet 112a of the first heat sink 110a is connected to the second liquid inlet 111b of the second heat sink 110b through the first sub-pipeline 121, the second liquid outlet 112b of the second heat sink 110b is connected to a third liquid inlet 111c of the third heat sink 110c through the second sub-pipeline 121a, a third liquid outlet 112c of the third heat sink 110c is connected to a fourth liquid inlet 111d of the fourth heat sink 110d through the third sub-pipeline 121b, and a fourth liquid outlet 112d of the fourth heat sink 110d is connected to the first liquid inlet 111a of the first heat sink 110a through the fourth sub-pipeline 121c, to form a circulation loop. Arrows on the pipelines in FIG. 9 and FIG. 10 indicate a flow direction of a cooling medium, and the pump body 130 may drive the cooling medium in the circulation loop to flow, to implement sharing of heat sinks on different components.

It may be understood that more than two other quantities of components may be further configured. By using the heat dissipation apparatus 100 in this embodiment of this application, heat sinks of different components are shared. This improves an overall heat dissipation capability. In addition, a plurality of heat sinks located on a same component may be connected in series or in parallel, as long as liquid paths on different components are connected to form a circulation loop.

In some embodiments, as shown in FIG. 6 to FIG. 8, the first heat sink 110a, the pipeline 120, and the second heat sink 110b are communicated to form a circulation loop. A control valve 140 is disposed on the pipeline 120, and connection and disconnection switching of the pipeline 120 may be controlled by using the control valve 140.

That the first component 200a and the second component 200b are boards is used as an example for description. When it is determined that at least one of the boards is in a backup state, or it is determined that boards with different power consumption exist, or it is determined that a predetermined temperature difference exists between the different boards when temperatures in different boards are read, the pump body 130 is turned on and the control valve 140 is opened, so that the cooling medium flows in the circulation loop, and heat in a heat sink corresponding to a high-temperature heat-generating device is conducted to a heat sink corresponding to a low-temperature heat-generating device or a non-working heat-generating device.

When it is determined that different boards do not have a predetermined temperature difference, heat generated by the heat-generating devices on the different boards is close to or equal to each other. The pump body 130 is turned off and the control valve 140 is closed, the cooling medium in the circulation loop does not flow, the heat generated by the heat-generating devices is conducted to the cooling medium in the heat sink through a corresponding heat sink, and the heat is dissipated outward through the heat sink.

The control valve 140 may be a solenoid valve, and the solenoid valve is convenient for controlling connection and disconnection switching of the pipeline 120.

In some embodiments, as shown in FIG. 6, the first heat sink 110a, the pipeline 120, and the second heat sink 110b are communicated to form a circulation loop, and a one-way valve 150 is disposed on the pipeline 120.

The one-way valve 150 is disposed, so that the cooling medium in the circulation loop can flow only in a same direction, and cannot flow reversely. This prevents the cooling medium from flowing back to the heat sink.

In some embodiments, as shown in FIG. 3 to FIG. 6, there are a plurality of heat fins 113 that are distributed at intervals on a side that is of the first heat sink 110a and that is opposite to the first heat-generating device 201a.

The first heat sink 110a has a plurality of heat fins 113. Heat generated by the first heat-generating device 201a during working is conducted to the heat fins 113 through the first heat sink 110a, and then is transferred to a surrounding environment through the heat fins 113. This effectively improves a heat dissipation capability.

In addition, there are a plurality of heat fins 113 that are distributed at intervals on a side that is of the second heat sink 110b and that is opposite to the second heat-generating device 201b. Heat generated by the second heat-generating device 201b can also be dissipated through the corresponding heat fins 113.

As shown in FIG. 3 to FIG. 10, an embodiment of this application provides a connection structure, including the heat dissipation apparatus 100, the first heat-generating device 201a, and the second heat-generating device 201b. The first heat-generating device 201a is in thermal contact with the first heat sink 110a, and the second heat-generating device 201b is in thermal contact with the second heat sink 110b.

According to the connection structure in this embodiment of this application, when heat-generating devices on different components have a specific temperature difference, a heat sink corresponding to a high-temperature heat-generating device transfers heat to a heat sink corresponding to a low-temperature heat-generating device by using a cooling medium, to implement uniform temperature heat dissipation effect of the heat-generating devices on different components. This improves a heat dissipation capability. A large pump body, pipeline, and heat exchanger are not required in an equipment room, and no additional indoor space is required.

There are different optional implementations when a component having a heat-generating device is arranged.

A first component arrangement manner: As shown in FIG. 8 and FIG. 9, the first component 200a is a first board, the second component 200b is a second board, and the first board and the second board are stacked. In this manner, a structure is compact and small space is occupied. The heat dissipation apparatus 100 in this embodiment of this application is used to form a cross-board heat balancing system, to implement uniform temperature heat dissipation effect of heat-generating devices on different boards.

A second component arrangement manner: The first component 200a is located on a first electronic device, and the second component 200b is located on a second electronic device. This manner is a cross-electronic device arrangement manner. Heat-generating devices of components on different electronic devices share the heat dissipation apparatus 100 in this embodiment of this application, to form a cross-board heat balancing system. This can implement uniform temperature heat dissipation effect of heat-generating devices of different electronic devices.

Both the first component 200a and the second component 200b may be boards.

An embodiment of this application provides an electronic device, including the foregoing heat dissipation apparatus 100 or the foregoing connection structure.

The electronic device may be various terminal devices, communication devices, data centers, or the like.

Because the foregoing heat dissipation apparatus 100 or connection structure is used, heat-generating devices on different components share a heat sink. This improves an overall heat dissipation capability.

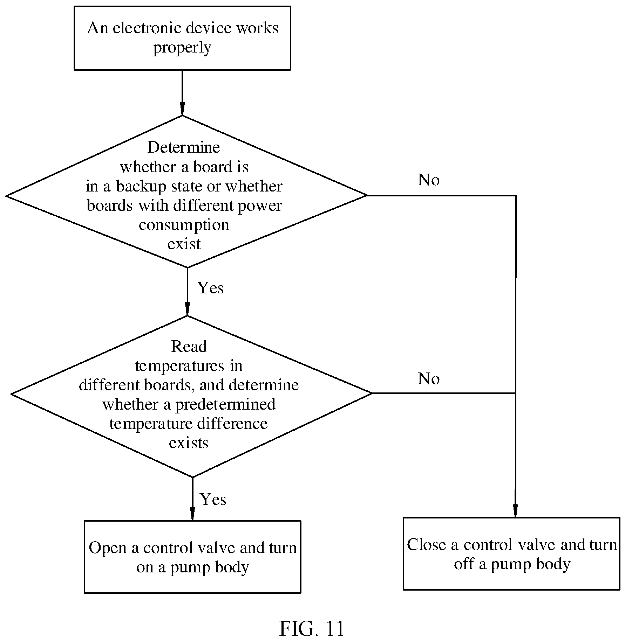

An embodiment of this application provides a heat dissipation method of an electronic device. As shown in FIG. 6 to FIG. 8, an example in which the first component 200a and the second component 200b are boards is used for description. The foregoing heat dissipation apparatus 100 is used for a plurality of boards, and the control valve 140 and the pump body 130 are disposed on the pipeline 120 in the heat dissipation apparatus 100. With reference to FIG. 11, the heat dissipation method of the electronic device includes the following steps.

When it is determined that at least one of the boards is in a backup state, or after it is determined that boards with different power consumption exist, temperatures in different boards are read and it is determined that a predetermined temperature difference exists between the different boards, the pump body 130 is turned on and the control valve 140 is opened, so that the cooling medium flows in the circulation loop, and heat in a heat sink corresponding to a high-temperature heat-generating device is conducted to a heat sink corresponding to the low-temperature heat-generating device or a non-working heat-generating device.

After it is determined that the board is not in a backup state, or it is determined that no board with different power consumption exists, the pump body 130 is turned off and the control valve 140 is closed. When temperatures in the different boards are read and it is determined that a predetermined temperature difference does not exist between the different boards, the pump body 130 is turned off and the control valve 140 is closed. In this case, the cooling medium in the circulation loop does not flow, heat generated by the heat-generating device is conducted to the cooling medium in the heat sink through the heat sink, and heat is dissipated outward through the heat sink.

According to the heat dissipation method of the electronic device in this embodiment of this application, when heat-generating devices on different boards have a specific temperature difference, the heat sink corresponding to the high-temperature heat-generating device transfers heat, by using the cooling medium, to the heat sink corresponding to the low-temperature heat-generating device or the non-working heat-generating device, to implement uniform temperature heat dissipation effect of the heat-generating devices on different boards. This improves a heat dissipation capability.

Finally, it should be noted that the foregoing descriptions are merely specific implementations of this application, but are not intended to limit the protection scope of this application. Any variation or replacement within a technical scope disclosed in this application shall fall within the protection scope of this application. Therefore, the protection scope of this application shall be subject to the protection scope of the claims.

## Claims

1. A heat dissipation apparatus, comprising: a first heat sink, a second heat sink, and a pipeline, wherein
the first heat sink has a first inner cavity, the second heat sink has a second inner cavity, the first heat sink is in thermal contact with a first heat-generating device located on a first component, and the second heat sink is in thermal contact with a second heat-generating device located on a second component; and
the first heat sink communicates with the second heat sink through the pipeline, and the first inner cavity, the second inner cavity, and the pipeline are filled with a cooling medium.

2. The heat dissipation apparatus according to claim 1, wherein the first heat sink, the pipeline, and the second heat sink are communicated to form a circulation loop, the pipeline is connected to a pump body, and the pump body is configured to drive the cooling medium to flow in the circulation loop; or
the pipeline is a heat pipe.

3. The heat dissipation apparatus according to claim 2, wherein the first heat sink, the pipeline, and the second heat sink are communicated to form the circulation loop, and the pipeline comprises a first sub-pipeline; and
the first heat sink has a first liquid inlet and a first liquid outlet, the second heat sink has a second liquid inlet and a second liquid outlet, and the first liquid outlet communicates with the second liquid inlet through the first sub-pipeline.

4. The heat dissipation apparatus according to claim 3, wherein the first sub-pipeline comprises a first liquid inlet pipe connected to the second liquid inlet, a first liquid outlet pipe connected to the first liquid outlet, and a first connection pipe connecting the first liquid inlet pipe and the first liquid outlet pipe, and the first liquid outlet pipe is connected to the first connection pipe through a pluggable connector.

5. The heat dissipation apparatus according to claim 4, wherein the pluggable connector and the first connection pipe are both disposed on a front panel or a rear panel of a device.

6. The heat dissipation apparatus according to claim 4 or 5, further comprising a second connection pipe, wherein the first connection pipe and the second connection pipe are crosswise disposed.

7. The heat dissipation apparatus according to any one of claims 2 to 6, wherein the first heat sink, the pipeline, and the second heat sink are communicated to form the circulation loop, and a control valve and/or a one-way valve are/is disposed on the pipeline.

8. The heat dissipation apparatus according to any one of claims 1 to 7, wherein there are a plurality of heat fins that are distributed at intervals on a side that is of the first heat sink and that is opposite to the first heat-generating device.

9. The heat dissipation apparatus according to any one of claims 1 to 8, wherein the first component is a first board, and/or the second component is a second board.

10. A connection structure, comprising the heat dissipation apparatus, the first heat-generating device, and the second heat-generating device according to any one of claims 1 to 9, wherein the first heat-generating device is in thermal contact with the first heat sink, and the second heat-generating device is in thermal contact with the second heat sink.

11. The connection structure according to claim 10, wherein the first component is a first board, the second component is a second board, and the first board and the second board are stacked.

12. The connection structure according to claim 10, wherein the first component is located on a first electronic device, and the second component is located on a second electronic device.

13. An electronic device, comprising the heat dissipation apparatus according to any one of claims 1 to 9, or the connection structure according to any one of claims 10 to 12.
